Europäisches Patentamt

European Patent Office

Office européen des brevets

(19)

(11) Publication number: **0 244 037**
**A1**

(12) **EUROPEAN PATENT APPLICATION**

(21) Application number: 87200796.8

(22) Date of filing: 27.04.87

(51) Int. Cl.4: **H04M 3/50** , G06F 3/16 , G06F 12/06 , G11C 8/00

(30) Priority: 28.04.86 NL 8601088

(43) Date of publication of application:
04.11.87 Bulletin 87/45

(84) Designated Contracting States:
CH DE FR GB LI NL SE

(71) Applicant: GROUP 2000 NEDERLAND B.V.
Bellavistastraat 5
NL-7604 AD Almelo(NL)

(72) Inventor: Wolters, Peter, Jacobus, Johannes,
Agnes,
Auskamplanden 137
NL-7542 AS Enschede(NL)

(74) Representative: van der Beek, George Frans
et al
Nederlandsch Octrooibureau Johan de
Wittlaan 15 P.O. Box 29720
NL-2502 LS 's-Gravenhage(NL)

(54) System for transmitting and/or switching signals.

(57) A system for transmitting and/or switching signals, in particular speech signals, comprising a memory for storing samples of the signals and a device for allocating the signal samples to a number of time miltiplex channels. The signals are stored in said memory in self-contained signal segments. Furthermore the allocating device is provided with a buffer memory (1, 2) with memory arrays assigned to the number of channels, in which the signal samples of the signal segments intended for the associated channel being written into each memory array. The read-out device is so designed that the first signal samples of the memory array, then the second, etc., are read out in sequence and transmitted in this sequence.

Fig-3

## System for transmitting and/or switching signals

The invention relates to a system for transmitting and/or switching signals, in particular speech signals, comprising a memory in which samples of the signals are stored and a device for allocating the signal samples to a number of time multiplex channels.

Said system can be realized by using microcomputers. The tasks of the microcomputer are essentially:
1. To determine which signals have to be assigned to which channel, and
2. To emit or fetch the signal samples on time.

The second task, in particular, presents a considerable load for the processor. In this connection, in known systems a microprocessor is used for each channel, a number of these processors having access to a common large speech memory. Disadvantages of such a system are:
-a kind of traffic controller is necessary which determines when a processor obtains access to the memory; this means that additional circuits have to be designed,
-if the text at the different outputs have a certain relationship to each other such as, for example, a holding message system, considerable information has to be exchanged mutually between the channels, either directly or by means of a special processor,
-large sections of the system are constructed for each channel and not once for each system, which has a cost-increasing effect.

The object of the invention is to provide a system of the type mentioned in the introduction in which the abovementioned disadvantages are avoided.

This object is achieved according to the invention in that the signals are stored in the memory in self-contained signal segments, in that the allocating device is provided with a buffer memory with memory arrays assigned to the number of channels, the signal samples of the signal segments intended for the associated channel being written into each memory array and in that the read-out device is so designed that the first signal samples of the memory array, then the second etc., are read out in sequence and transmitted in this sequence.

According to a further development of the invention, the read-out device contains a binary counter, the bit outputs of which are connected to the address bit lines of the read-out device in a cyclically offset manner such that the bit output 0 of the counter is connected to the address bit line X of the read-out device, for which it holds true that $2^X = 2^A : 2^K$, $2^A$ being the number of addresses of the buffer memory and $2^K$ the number of channels.

In an embodiment of the invention, with a buffer memory having a width of $2^B$ bytes, B bits of the counter having the sequence number K up to and including K + B - 1 are not connected to an address bit line, the number of bit outputs of the counter being equal to the number of address bit lines augmented by the number of unconnected bit outputs.

Preferably the unconnected bit outputs of the counter are used for switching over to the adjacent bytes.

In another embodiment of the invention the parallel bit outputs are connected via a parallel-series convertor to a multiplexer.

In yet another embodiment the buffer memory is doubled.

The invention will now be explained in more detail on the basis of the drawings. In the drawings:
Figure 1 shows a PCM frame;
Figure 2 shows the organization of a speech memory;
Figure 3 shows a block diagram of an interface for generating a PCM bit current; and
Figure 4 shows the partitioning of the buffer memory of Figure 3.

The invention is described hereafter on the basis of an exemplary embodiment for speech signals, but it is clear to those skilled in the art that the invention is equally applicable for signals of another type.

In engineering use is being made to an increasing extent of (micro) computers which are capable of reading in or outputting speech signals. Since all the signals to be processed by a computer are digital, use must also be made of speech signals in digital form. Although there are many methods of digitizing speech signals, the starting point in this case is exclusively pulse-code modulation and, in particular, in accordance with the much used and well defined standard method according to CCITT recommendation G.701-G.941. Said recommendation has been developed in principle for the transmission technique. For this reason, in said recommendations, not only is the method of digitizing speech signals laid down, but also the manner of being able to send a large number of speech signals over a single core pair. Main characteristics of said method are:

-the various speech signals are sent one after another according to the time multiplexing principle. 24 or 30 channels may be used, synchronization signals being sent along the transmission channel at the same time in order to be able to determine the position of each channel in time by means thereof.

-the units of information (bits) are transmitted in serial form.

The invention is particularly suitable for message systems. The Applicant has designed a family of message systems which have the following in common:

-digitally stored message texts,

-use of the speech digitization method recommended by the CCITT, and

-use of the primary PCM multiplexing method also recommended by CCITT.

The most prominent reason for using said multiplexing method is that it is possible by means thereof to distribute a large number of different message texts in an electronic system via only two wires. However, it is also possible to use the method in collecting many digital speech signals originating from just as many sources in order to store them in a central message memory.

In order to illustrate the use of many different message texts, there follows a short description of some important applications.

A holding message system

A holding message system is connected to a number of telephone lines varying between, for example, 4 and 64. The system may be connected between a public telephone exchange and a private exchange. If the private exchange switchboard does not answer the incoming telephone traffic immediately for one reason or another, the holding message system can answer this call and then provide a preprogrammed message which is stored in a digital speech memory. The content of the memory may be, inter alia, that the caller learns how many callers are waiting for an answer in front of him. It is also possible, for example, for a general out-of-service message to be given outside the office hours. Other message texts may, for example, consist of advertising messages which are specific to the firm concerned. Characteristic of the system is the fact that each incoming telephone line is supplied with an individual message having variable duration and its own start and finishing times. Such a message is made up of short segments of text which are stored in the speech memory.

Voice mailbox

A voice mailbox is a system which is also coupled to a large number of telephone lines and which can be used as a centrally installed large answering machine. Said system is capable of processing calls for individuals or operating units which are temporarily inaccessible. The caller is provided with the opportunity of speaking a message which is stored in digital form in a large memory. The system is independently capable of calling up or telephoning the person for whom the message was intended and of playing back the stored message when this call is answered. The message is then removed from the memory.

Characteristic of this system is the fact that it has to be possible to digitize and store a large of number of messages at the same time. It must also be possible to play back all the messages again at a later time.

Call distributor

A call distributor is a system which can be used for a group of switchboards with the simultaneous distribution of the incoming telephone traffic over all the individuals manning said switchboards as the main task. Just as in the case of the holding message system, this involves a system which is capable of answering telephone calls and delivering a message to the caller. In this case messages can be offered which correspond with those mentioned in the case of the holding message system.

However, in contrast to the holding message system, in the case of the call distributor the incoming telephone calls have also to be digitized and then distributed over the switchboards.

Digital message systems for general applications

In addition to the abovementioned applications which have in common the fact that they are used in the telephone network, many others are also conceivable. An example is the provision of spoken information in lifts such as the approach of a lift for individuals awaiting it or the number of an approaching floor for individuals in a lift. If such a system is used for a group of different lifts, this again involves many messages starting and finishing independently of each other.

The most important characteristics of the message systems mentioned, in which the series-parallel and parallel-series conversion to be described is used, are:

-use of digital speech signals,

-many message outputs,

-many message inputs,

-messages are given or read-in simultaneously,

-individual start and stop times,

-construction of messages from stored segments,

-distribution of message texts by means of a first-order PCM multiplexing structure,

-control by means of a microprocessor.

In order to make it possible to form a good picture of the problems relating to the operation of many digital message texts presented in parallel, a brief description is given of the CCITT recommendation relating to digital speech transmission and of the method in which digital speech signals are in general stored in a memory.

The recommendation relates to two different methods, viz. the so-called North American and the European standard. The first involves 24 and the second 30 different speech channels which are individually digitized. Hereafter the European system with 30 channels will be dealt with exclusively since there is no difference in principle between the two methods.

The series-parallel and parallel-series conversion is applicable to both recommendations. A detailed description will also be given exclusively of the parallel-series conversion since the series-parallel conversion proceeds in a completely identical manner. In the last-named, a reverse sequence of corresponding devices is used.

The frequency band of a speech signal is limited to 4 kHz and the signal is then sampled at 8 kHz. All speech samples are quantized in 8 bits according to a logarithmic quantization curve. The reason for using this logarithmic compression is not relevant here. Said 8 bits are sent in series, the most significant bit being sent first. This process takes place simultaneously for 30 channels, after which the digital code words of 8 bits associated with the 30 channels are sent in series. After the first speech sample has been sent for all 30 channels, the next sample is sent for all the channels.

In addition to the 30 speech channels mentioned, a synchronization and a signalling channel are also sent so that the total number of channels per cycle (or frame) is 32. The transmission speed is therefore 32 × 8,000 × 8 = 2,048,000 bits per second.

The information in the synchronization channel is used to specify the start of the frame.

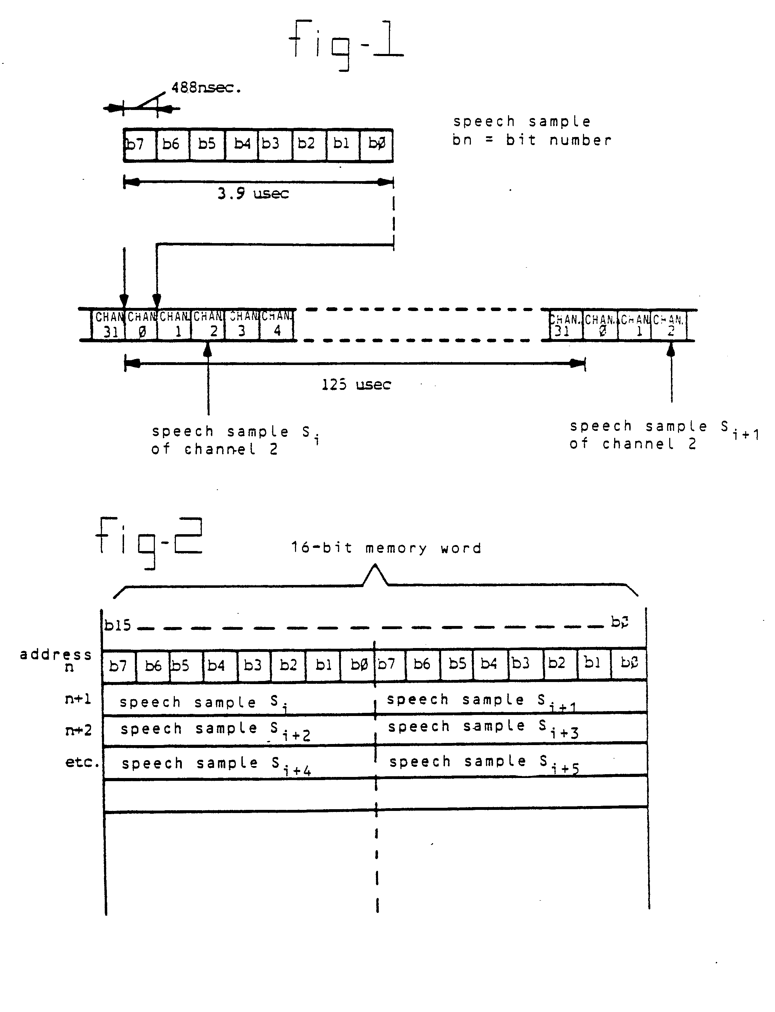

The partitioning of the PCM frame of first order is shown in Figure 1. It is thus evident that only 1 byte is sent per channel and only after this has occurred for 30 (32) channels is it the turn of the first channel again. This amounts to an interval between two speech samples in the same channel of precisely 125 microseconds.

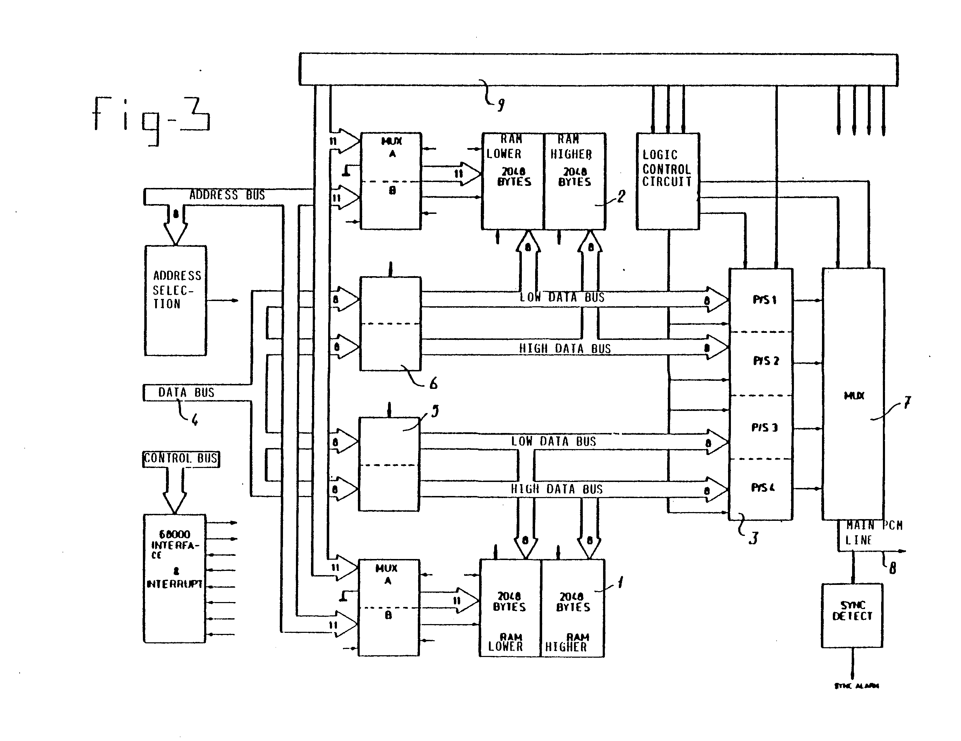

The message texts are stored in digital form in standard electronic memories or memories of another type. The latter are so designed that data words having a "width" of 8, 16 or even 32 bits can be stored. Figure 2 shows an example of the manner in which the storage of PCM samples of 8 bits of a segment of a speech is performed in a memory of, for example, 16 bits.

In the applications mentioned earlier it has been assumed that such a system is controlled by a microcomputer. The tasks of the latter are primarily:

-determining which segments of text have to be delivered to which output,

-the sending (or fetching) of the speech samples.

Measured on the timescale of a microprocessor, segments of speech usually have a relatively long duration so that the first task forms a relatively low load on the processor. The second task implies, however, that for each output channel a new speech sample has to sent every 125 microseconds. Since a message is provided simultaneously for 32 channels, only approximately microseconds are available for retrieving and sending each speech sample. For this reason, one microprocessor per output channel is sometimes used in existing solutions, the disadvantages of which have already been mentioned earlier.

In order to achieve as large a cost saving as possible for message systems, the method of speech digitization recommended by CCITT and first-order PCM multiplexing has been chosen as the most important starting point. The most important reason for this is that specific integrated circuits have been developed by the semi-conductor industry for use in telecommunications which can be connected directly to a PCM bit flow of 2,048 megabit/sec. These compact ICs can take the digital speech samples from a selected channel and convert them directly into an analog system so that this analog signal is immediately suitable for supplying to, for example, a telephone line.

In view of the nature of the PCM bit flow, the microprocessor has to fetch and send one sample at a time for each channel from the speech memory. This means that considerable additional work has to be done for each sample transported in switching from channel to channel. The best method would be to send a large number of samples for each channel and consequently for each segment of speech, all at once. As a result of this the handling of a channel by the microprocessor is interrupted as little as possible by the handling of the other channels. This would, however, be possible only if the samples were stored in the speech memory in the sequence in which they are included in the PCM bit flow. This is, however, in conflict with the possibility of presenting mutually independent and variable messages for each channel.

In order to avoid the above problems the speech signals are stored according to the invention as self-contained segments in a memory. A required text for a certain channel can be made up from these segments.

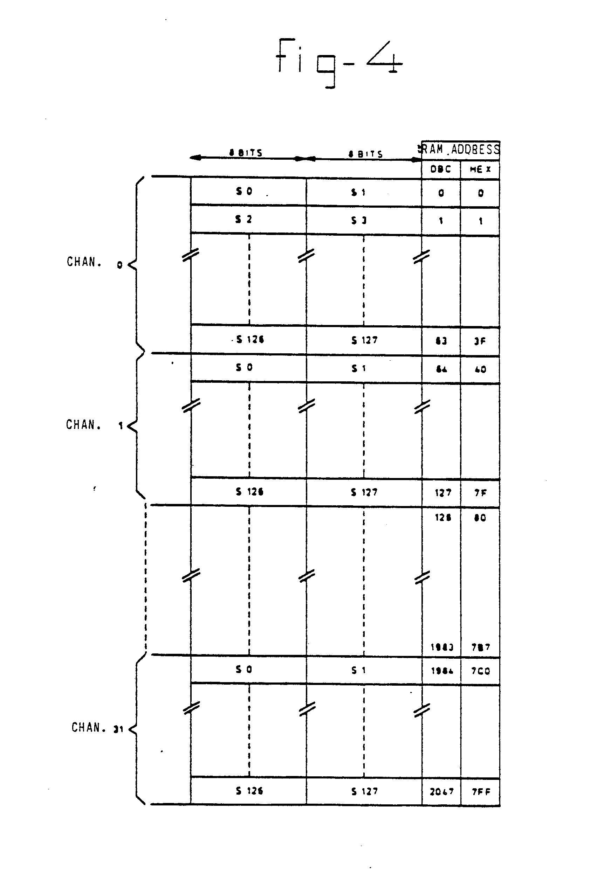

Figure 3 shows an interface according to the invention for the generation of such a PCM bit flow in a microcomputer system, which interface consists of the following most important components:
    -a buffer memory 1 which consists of a lower and higher section.

This buffer memory provides the microcomputer with the option of also forming tasks other than exclusively transporting speech samples. Said buffer memory which may contain 4,096 samples of 8 bits can rapidly be filled by the microprocessor. Then the samples are read out one by one and fed into the PCM bit flow. The interface contains two identical buffer memories 1 and 2, so that the microprocessor can fill one of the buffer memories 1, 2 while the other is being read out in the meantime. It is necessary for filling to take place more rapidly than reading out. If a buffer memory 1, 2 is empty, the microprocessor receives a signal (interrupt) and is switched over to the other buffer memory 2, 1 which has been filled in the meantime. After receiving the interrupt, the microprocessor fills the buffer memory just read out again and then performs other tasks until a new interrupt appears as an indication that one of the buffer memories 1, 2 has been read out completely. This process is repeated continuously.

A parallel-series convertor 3

The two buffer memories 1, 2 are read out in parallel. These 8-, 16-or 32-bit words, which each consist in turn of one or more digital speech samples, are converted by the parallel-series convertor into a serial bit flow of 2,048 megabits per second.

If a buffer memory 1, 2 is empty and the interface sends an interrupt to the microprocessor, 128 speech samples per channel are read out of the speech memory and written into the buffer memory 1, 2 via the data bus 4 and the tristate buffer 5, 6. This in general involves a section of a segment having a duration of $128 \times 125 = 16,000$ microseconds. After $128 \times 32$ (samples times channels) = 4,096 samples have been sent, the buffer memory 1, 2 is exactly filled. The contents of the buffer memory 1, 2 are shown diagrammatically in Figure 4.

After this, access to the buffer memory 1, 2 is blocked by the tristate buffer 5, 6 connected to it and the buffer memory concerned is read out. In the meantime the other buffer memory 2, 1 has already been emptied and is filled via the tristate buffer 6, 5 connected to it in the same manner as for the buffer memory mentioned earlier.

The great strength of the interface lies in the manner in which the buffer memory is read out. The addresses which have to be read out in sequence in order to fill the PCM bit flow in the correct manner have the following sequence:

```
0000    0064    0128.....1984    0000    0064    0128.....1984
0001    0065    0129.....1985    0001    0065    0129.....1985
  .       .       .                .       .       .       .
  .       .       .                .       .       .       .
0063    0127    1983.....2047    0063    00127   1983.....2047
```

Each line consists of two identical parts so that the same series of 32 numbers are therefore generated twice one after the other. This is because two samples of 8 bits are stored in this example in each memory location. In a memory which is 8 or 32 bits wide, comparable series can be generated. The first time, for example, the most significant half of the memory location is connected through in series to the PCM output 8 by means of the parallel-series convertor 3 and the multiplexer 7. The second time the same location is read, it is done with the least significant half.

The Applicant has found a particularly simple method for reading out each buffer memory in the manner described above. A standard binary counter 9 which traverses the following series: 0000 0001 0002 0003 0004 0005 0006 0007 etc., is used to generate the read-out addresses. Said counter is not connected to the address bit lines of the buffer memory in the conventional manner but in an unusual manner usually described "wrong". For this purpose, the buffer addresses are defined as follows:

most-significant

ad10 ad09 ad08 ad07 ad06 ad05 ad04

least-significant

ad03 ad02 ad01 ad00

These buffer addresses are connected through to the counter outputs as follows:

most-significant

ct04 ct03 ct02 ct01 ct00 ct11 ct10

least-significant

ct09 ct08 ct07 ct06.

The bit outputs of the counter are, as it were, connected in a cyclically offset manner to the address bit lines, the bit output 0 of the counter being connected to the address line X of the read-out device for which it holds true that $2^x = 2^A:2^K$, $2^A$ being the number of addresses of the buffer memory and $2^K$ the number of channels. In this embodiment the bit output 0 of the counter is connected to the address bit line 6, while the fifth bit output of the counter is not coupled to an address bit line. This fifth bit output of the counter is used for switching over from the most-significant section to the least-significant section of the buffer memory 1, 2. As a result the required address sequence is achieved in a very simple manner, which sequence is as follows:

$$00000000000 = 0000$$
$$00001000000 = 0064$$
$$00010000000 = 0128$$
$$.$$
$$.$$
$$11111000000 = 1984$$
$$00000000000 = 0000$$
$$.$$
$$.$$
$$11111000000 = 1984$$
$$00000000001 = 0001$$

If the buffer memory is one byte wide, the number of bit outputs of the counter is equal to the number of address bit lines of the buffer memory, the abovementioned cyclic offset connection being used. If, however, a buffer memory with a width of 4 bytes is used, the bit outputs 5 and 6 are not connected to an address bit line of the buffer memory, the number of bit outputs of the counter being equal to the number of address bit lines plus the number of unconnected bit outputs of the counter. In general it holds true that in a buffer memory of $2^B$ bytes, B bits have to be stored. The omitted bits of the sequence number K up to and including K + B - 1, $2^K$ being the number of channels used and B being an integer beginning with 0.

## Claims

1. System for transmitting and/or switching signals, in particular speech signals, comprising a memory in which samples of the signals are stored and a device for allocating the signal samples to a number of time multiplex channels, characterized in that the signals are stored in the memory in self-contained signal segments, that the allocating device is provided with a buffer memory with memory arrays assigned to the number of channels, the signal samples of the signal segments intended for the associated channel being written into each memory array, and in that the read-out device is so designed that the first signal samples of the memory array, then the second, etc., are read out in sequence and transmitted in this sequence.

2. System according to Claim 1, characterized in that the read-out device contains a binary counter, the bit outputs of which are connected to the address bit line of the read-out device in a cyclically offset manner, such that the bit output 0 of the counter is connected to the address bit line X of the read-out device, for which it holds true that $2^X = 2^A : 2^K$, $2^A$ being the number of addresses of the buffer memory and $2^K$ the number of channels.

3. System according to Claim 2, characterized in that, with a buffer memory having a width of $2^B$ bytes, B bits of the counter with the sequence number K up to and including K + B - 1 are not connected to an address bit line, and in that the number of bit outputs of the counter is equal to the number of address bit lines augmented by the number of unconnected bit outputs.

4. System according to Claim 3, characterized in that the unconnected bit outputs of the counter are used for switching over to the adjacent bytes.

5. System according to one of the preceding claims, characterized in that the parallel buffer outputs are connected via a parallel-series convertor to a multiplexer.

6. System according to one of the preceding claims characterized in that the buffer memory is doubled.

# fig-1

488nsec.

| b7 | b6 | b5 | b4 | b3 | b2 | b1 | b∅ |

speech sample
bn = bit number

3.9 usec

| CHAN. 31 | CHAN. ∅ | CHAN. 1 | CHAN. 2 | CHAN. 3 | CHAN. 4 | . . . | CHAN. 31 | CHAN. ∅ | CHAN. 1 | CHAN. 2 |

125 usec

speech sample $S_i$
of channel 2

speech sample $S_{i+1}$
of channel 2

# fig-2

16-bit memory word

| | b15 — — — — — — — — — — — — — — b∅ | |
|---|---|---|
| address n | b7 \| b6 \| b5 \| b4 \| b3 \| b2 \| b1 \| b∅ | b7 \| b6 \| b5 \| b4 \| b3 \| b2 \| b1 \| b∅ |
| n+1 | speech sample $S_i$ | speech sample $S_{i+1}$ |
| n+2 | speech sample $S_{i+2}$ | speech sample $S_{i+3}$ |
| etc. | speech sample $S_{i+4}$ | speech sample $S_{i+5}$ |
| | | |
| | | |

Fig-3

ADDRESS BUS

ADDRESS SELECTION

DATA BUS

CONTROL BUS

68000 INTERFACE & INTERRUPT

MUX A

8

B

11

11

RAM LOWER 2048 BYTES

RAM HIGHER 2048 BYTES

LOGIC CONTROL CIRCUIT

LOW DATA BUS

HIGH DATA BUS

LOW DATA BUS

HIGH DATA BUS

PIS 1

PIS 2

PIS 3

PIS 4

MUX

MAIN PCM LINE

SYNC DETECT

SYNC ALARM

2048 BYTES RAM LOWER

2048 BYTES RAM HIGHER

0 244 037

# Fig-4

| | 8 BITS | 8 BITS | RAM. ADDRESS | |
|---|---|---|---|---|
| | | | DEC | HEX |

| CHAN. | | 8 BITS | 8 BITS | DEC | HEX |
|---|---|---|---|---|---|
| CHAN. 0 | | S 0 | S 1 | 0 | 0 |
| | | S 2 | S 3 | 1 | 1 |
| | | // | // | // | |
| | | S 126 | S 127 | 63 | 3F |
| CHAN. 1 | | S 0 | S 1 | 64 | 40 |
| | | // | // | // | |
| | | S 126 | S 127 | 127 | 7F |
| | | | | 128 | 80 |
| | | // | // | // | |
| | | | | 1983 | 7B7 |
| CHAN. 31 | | S 0 | S 1 | 1984 | 7C0 |
| | | // | // | // | |
| | | S 126 | S 127 | 2047 | 7FF |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 357 493 (ANDERSON et al.) <br> * Page 1, abstract; column 7, line 17 - column 8, line 12; column 11, lines 10-31 * | 1,5 | H 04 M 3/50 <br> G 06 F 3/16 <br> G 06 F 12/06 <br> G 11 C 8/00 |
| A | | 3,4,6 | |
| | --- | | |
| X | US-A-4 545 043 (ANDERSON et al.) <br> * Column 1, lines 6-15; column 6, line 53 - column 7, line 15; column 8, lines 30-38 * | 1,5,6 | |
| A | | 3,4 | |
| | --- | | |
| X | THE BELL SYSTEM TECHNICAL JOURNAL, vol. 60, no. 6, July-August 1981, pages 1083-1108, American Telephone and Telegraph Co., Murray Hill, US; T.W. ANDERSON et al.: "Mass announcement subsystem" <br> * Page 1097, lines 4-15 * | 1,5 | TECHNICAL FIELDS SEARCHED (Int. Cl.4) <br><br> H 04 M <br> H 04 Q <br> G 06 F <br> G 11 C |
| A | Idem | 3,4,6 | |
| | ---     -/- | | |

The present search report has been drawn up for all claims

| Place of search | Date of completion of the search | Examiner |
|---|---|---|
| THE HAGUE | 06-08-1987 | DE MUYT H.A. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| X | US-A-3 990 050 (KOLETTIS et al.)<br>* Column 6, line 44 - column 7, line 13; column 8, line 49 - column 13, line 51; column 18, line 62 - column 19, line 13; column 19, line 53 - column 21, line 31 * | 1,3,5, 6 | |
| A | | 2,4 | |
| | --- | | |
| A | DE-A-3 423 818 (TELEFONBAU UND NORMALZEIT GmbH)<br>* Page 9, line 32 - page 10, line 11 * | 1-4 | |
| | --- | | |
| A | FR-A-2 367 399 (LE MATERIEL TELEPHONIQUE)<br>* Page 8, lines 15-19; page 9, lines 13-22 * | | TECHNICAL FIELDS SEARCHED (Int. Cl.4) |
| | --- | | |
| A | DE-A-2 525 025 (TELEFONBAU UND NORMALZEIT GmbH)<br>* Page 7, lines 1-7; page 12, lines 22-31 * | 1,6 | |
| | ---     -/- | | |

The present search report has been drawn up for all claims

| Place of search | Date of completion of the search | Examiner |
|---|---|---|
| THE HAGUE | 06-08-1987 | DE MUYT H.A. |

Page 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PROCEEDINGS OF THE NATIONAL ELECTRONICS CONFERENCE, Chicago, 10th-12th October 1977, vol. XXXI, pages 250-255, National Engineering Consortium Inc., Chicago, US; J.W. LITTERER: "No. 3 EAX peripheral architecture" * Page 251, right-hand column, lines 1-50; page 252, left-hand column, line 48 - right-hand column, line 12 * | 1,6 | |
| A | REVIEW OF THE ELECTRICAL COMMUNICATION LABORATORIES, vol. 32, no. 6, November 1984, pages 1003-1009, Tokyo, JP; M. OHYAMA et al.: "Voice storage equipment" * Page 1006, paragraph 3.2.2; page 1007, left-hand column, paragraph 2; page 1007, right-hand column, paragraph 4 * | 1,6 | |
| A | EP-A-0 081 066 (NEUMANN) * Page 5, line 14 - page 9, line 6; figure 3 * | 1-6 | |
| A | FR-A-2 222 698 (INTREPRINDEREA) * Whole document * | 2-4 | |
|  | --- -/- | | |

TECHNICAL FIELDS SEARCHED (Int. Cl.4)

The present search report has been drawn up for all claims

| Place of search | Date of completion of the search | Examiner |
|---|---|---|
| THE HAGUE | 06-08-1987 | DE MUYT H.A. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PROCEEDINGS OF THE 1981 INTERNATIONAL CONFERENCE ON PARALLEL PROCESSING, Columbus, Ohio, 25th-28th August 1981, pages 318-324, IEEE; T. YUN-KUEI et al.: "An analysis of a new memory system for conflict-free access" <br> * Whole document * | 2-4 | |
| | ----- | | |
| | | | TECHNICAL FIELDS SEARCHED (Int. Cl.4) |

The present search report has been drawn up for all claims

| Place of search | Date of completion of the search | Examiner |
|---|---|---|
| THE HAGUE | 06-08-1987 | DE MUYT H.A. |